# EUROPEAN PATENT APPLICATION

(11) **EP 4 693 411 A1**
(43) Date of publication of application: **11.02.2026**
(21) Application number: 24810378.0
(22) Date of filing: 21.05.2024
(51) Int. Cl.: H01L 31/02

(54) **BACK CONTACT BATTERY, BATTERY ASSEMBLY, AND PHOTOVOLTAIC SYSTEM**

(30) Priority: 22.05.2023 CN 202310580520; 22.05.2023 CN 202321247872 U
(71) Applicant: Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN)
(72) Inventor: TAN, Lixiang, Zhuhai, Guangdong 519000 (CN); WANG, Yongqian, Zhuhai, Guangdong 519000 (CN); ZHANG, Ning, Zhuhai, Guangdong 519000 (CN); SONG, Yi, Zhuhai, Guangdong 519000 (CN); CHEN, Gang, Zhuhai, Guangdong 519000 (CN)
(74) Representative: EP&C
(86) International application number: PCT/CN2024/094375
(87) International publication number: WO 2024/240136

(57) **Abstract**

The present application is applicable to the technical field of solar cells, and provides a back contact cell (100), a solar module and a photovoltaic system. The back contact cell (100) includes a cell substrate (10) and first insulation members (21); alternately arranged fingers having two polarities are formed on a back surface of the cell substrate (10); the back surface includes current collection regions (13) and non-current collection regions (14) which are distributed in a staggered manner; and the first insulation members (21) are arranged at edges of the non-current collection regions (14) in a continuous manner in an extension direction of the current collection regions (13), and cover portions of the fingers located in the non-current collection regions (14) close to the current collection regions (13).

## Description

The present application claims priority to Chinese Patent Application no. 2023105805203, to the China National Intellectual Property Administration on May 22, 2023 and entitled "Back Contact Cell, Solar Module and Photovoltaic System", which is incorporated herein by reference in its entirety.

### Technical Field

The present application relates to the technical field of solar cells, and in particular, to a back contact cell, a solar module and a photovoltaic system.

### Background

Solar cell power generation is a sustainable source of clean energy, which can convert sunlight into electrical energy using the photovoltaic effect of a semiconductor p-n junction.

In the back contact cells in the related art, the fingers having two polarities are distributed in a staggered manner. When bus bars are used to collect current from fingers, the fingers are prone to be electrically connected to bus bars of an opposite polarity, thereby causing a short circuit.

### Technical Problem

How to reduce the risk of short circuit of the back contact cell becomes a problem to be solved urgently.

### Technical Solution

The present application provides a back contact cell, a solar module and a photovoltaic system, which are intended to solve the problem of reducing the risk of short circuit of the back contact cell.

The back contact cell provided in the present application includes a cell substrate and first insulation members, where fingers having two polarities are alternately arranged on a back surface of the cell substrate; the back surface includes current collection regions and non-current collection regions which are distributed in a staggered manner; and the first insulation members are arranged at the edges of the non-current collection regions in a continuous manner in an extension direction of the current collection regions, and cover portions of the fingers located in the non-current collection regions close to the current collection regions.

The solar module provided in the present application includes any one of the described back contact cells.

The photovoltaic system provided in the present application includes the described solar module.

### Beneficial Effects

According to the back contact cell, the solar module and the photovoltaic system of the embodiments of the present application, since the first insulation members are continuously arranged at the edge of the non-current collection region in the extension direction of the current collection region, covering the portions of the fingers located in the non-current collection region close to the current collection region, it prevents, at the edge of the non-current collection region close to the current collection region, the fingers from being in conduct with current collectors of an opposite polarity, thereby ensuring the normal operation of the back contact cell and reducing the risk of short circuit.

### Brief Description of the Drawings

Fig. 1 is a schematic structural diagram of a back contact cell according to an embodiment of the present application;
Fig. 2 is a schematic structural diagram of a cell substrate of a back contact cell according to an embodiment of the present application;
Fig. 3 is a schematic structural diagram of a partial region of a back contact cell according to an embodiment of the present application;
Fig. 4 is a schematic structural diagram of a partial region of a back contact cell according to an embodiment of the present application;
Fig. 5 is a schematic structural diagram of a partial region of a back contact cell according to an embodiment of the present application;
Fig. 6 is a schematic structural diagram of a partial region of a back contact cell according to an embodiment of the present application;
Fig. 7 is a schematic structural diagram of a partial region of a back contact cell according to an embodiment of the present application;
Fig. 8 is a schematic structural diagram of a partial region of a back contact cell according to an embodiment of the present application;
Fig. 9 is a schematic structural diagram of a partial region of a back contact cell according to an embodiment of the present application;
Fig. 10 is a schematic structural diagram of a back contact cell according to an embodiment of the present application;
Fig. 11 is a schematic structural diagram of a back contact cell according to an embodiment of the present application;
Fig. 12 is a schematic structural diagram of a back contact cell according to an embodiment of the present application;

### Explanation of main components and symbols:

back contact cell 100, cell substrate 10, interconnector electrical connection region 101, first finger 111, first busbar 112, first interconnector electrical connection region 1120, second finger 121, second busbar 122, second interconnector electrical connection region 1220, current collection region 13, non-current collection region 14, first insulation member 21, second insulation member 22, third insulation member 23 and limiting member 24.

### Detailed Description of the Embodiments

To make the objectives, technical solutions, and advantages of the present application clearer, the present application is further described in details below in combination with the drawings and embodiments. Examples of the embodiments will be illustrated in the accompanying drawings, where throughout the description, same or similar reference numerals represent same or similar elements or elements with same or similar functions. The embodiments described below with reference to the accompanying drawings are illustrative, and are intended to illustrate the present application, and shall not be understood as limiting the present application. In addition, it should be understood that the specific embodiments described herein are only used to explain the present application, and are not intended to limit the present application.

In the description of the present disclosure, it should be understood that, orientations or position relationships indicated by terms such as "length", "width", "upper", "lower", "left", "right", "horizontal", "top", "bottom" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present application.

In addition, the terms "first" and "second" are only used for descriptive purposes, and cannot be understood as indicating or implying relative importance or implicitly indicating the number of indicated technical features. Thus, features defined by "first" and "second" may explicitly or implicitly include one or more of the features. In the description of the present application, "a plurality of" refers to two or more than two, unless specified otherwise.

In the description of the present application, it should be noted that, unless stated and limited otherwise, terms "installing", "connected", and "connection" should be understood in broader sense. For example, connection may be a fixed connection, a removable connection, or an integrated connection, may be a mechanical connection, an electrical connection, and may be a direct connection, an indirect connection through a medium, or a communication connection between two components or an interaction connection between two components, unless limited otherwise. For those of ordinary skill in the art, the specific meanings of the above terms in the present application can be understood according to specific situations.

In the present application, unless specified or limited otherwise, a first feature being "above" or "below" a second feature may include a direct contact between the first feature and the second feature, and may also include another feature contact between the first feature and the second feature rather than a direct contact. In addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present application. In order to simplify the disclosure of the present application, components and settings of specific examples are described below. Of course, they are merely examples and are not intended to limit the present application. Furthermore, the present application may repeat reference numerals and/or reference letters in different examples for the purpose of simplicity and clarity, and does not in itself indicate a relationship between the various embodiments and/or arrangements discussed. In addition, the present application provides examples of various specific processes and materials, but those skilled in the art will recognize the application of other processes and/or the use of other materials.

In the present application, since the first insulation members are continuously arranged at the edge of the non-current collection region in the extension direction of the current collection region, covering the portions of the fingers located in the non-current collection region close to the current collection region, it prevents, at the edge of the non-current collection region close to the current collection region, the fingers from being in conduct with current collectors of an opposite polarity, thereby ensuring the normal operation of the back contact cell and reducing the risk of short circuit.

### Embodiment 1

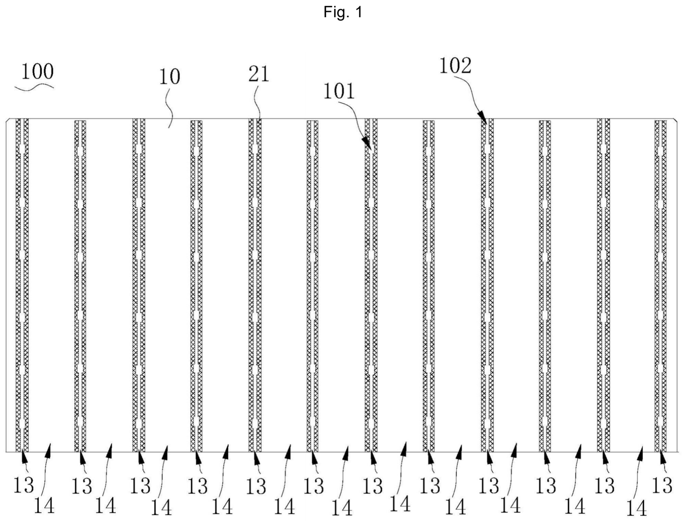

Please refer to Figs. 1, 2 and 3, a back contact cell 100 of an embodiment of the present application includes a cell substrate 10 and first insulation members 21; alternately arranged fingers having two polarities are formed on a back surface of the cell substrate 10; the back surface includes current collection regions 13 and non-current collection regions 14 which are distributed in a staggered manner; and the first insulation members 21 are arranged at edges of the non-current collection regions 14 in a continuous manner in an extension direction of the current collection regions 13, and cover portions of the fingers located in the non-current collection regions 14 close to the current collection regions 13.

In the back contact cell 100 of the embodiment of the present application, since the first insulation members 21 are continuously arranged at the edge of the non-current collection region 14 in the extension direction of the current collection region 13, covering the portions of the fingers located in the non-current collection region 14 close to the current collection region 13, it prevents, at the edge of the non-current collection region 14 close to the current collection region 13, the fingers from being in conduct with current collectors of an opposite polarity, thereby ensuring the normal operation of the back contact cell 100 and reducing the risk of short circuit of the back contact cell 100.

Furthermore, when a plurality of back contact cells 100 are stacked, the fingers may be prevented from scratching another back contact cell 100 by the first insulation members 21 in the region which is covered with the first insulation members 21. Furthermore, since the first insulation member 21 has a certain thickness, a gap may be formed between a region which is not covered with the first insulation members 21 and another back contact cell 100, thereby preventing the fingers from scratching the another back contact cell 100 in the region which is not covered with the first insulation members 21. In this way, when the back contact cells 100 are stacked, a damage to the back contact cells 100 can be reduced, and a separator sheet provided between two adjacent back contact cells 100 can be omitted, thereby reducing costs of transporting or storing the back contact cells 100.

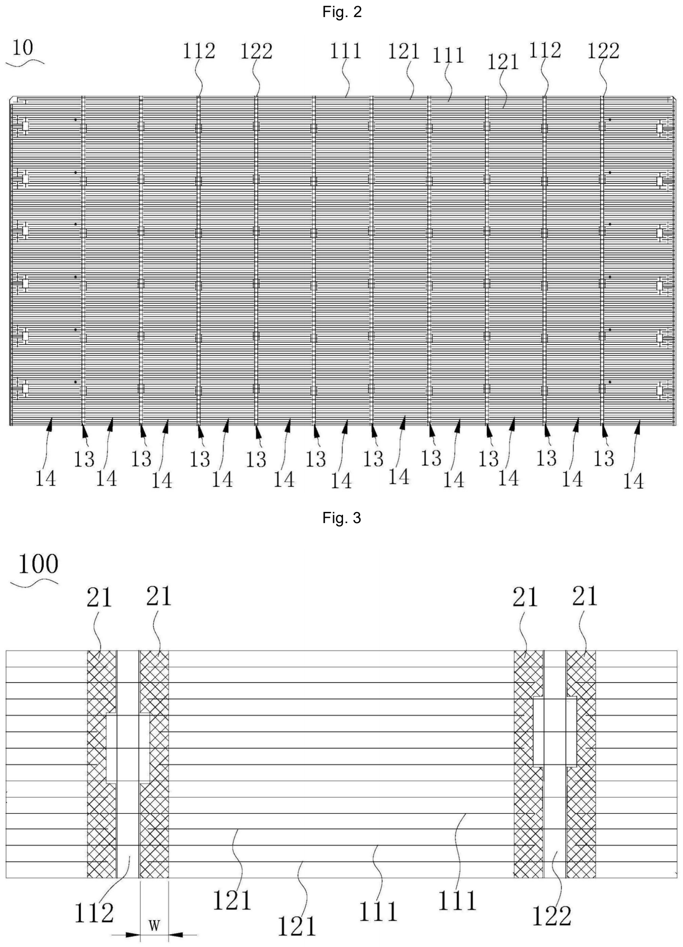

Optionally, the back contact cell 100 may be a whole cell piece, or may be a half-cell, a one-third cell, or other proportionally divided cell obtained by splitting a whole cell piece. To make the drawings clearer, the back contact cell 100 shown in Figs. 1 and 2 is a half-cell divided from a whole cell piece. The back contact cell 100 of other proportionally divided forms are similar to those in Figs. 1 and 2, reference may be made to Figs. 1 and 2, and it will not be repeated here. Figs. 3 to 9 show some regions of the back contact cell 100, and other region of the back contact cell 100 are similar to those shown in Figs. 3 to 9, reference may be made to Figs. 3 to 9, and it will not be repeated here. That is, the drawings are only examples, and do not represent limitations to the specific form of the back contact cell 100.

Optionally, fingers having two polarities, which are first fingers 111 and second finger 121 respectively, are distributed on the back surface of the cell substrate 10 in a staggered manner.

Optionally, the cell substrate 10 includes a front surface and a back surface which are opposite to each other; the front surface faces the sun and mainly receives direct sunlight; the back surface faces a mounting surface of the solar module and mainly receives sunlight reflected by the mounting surface; and the mounting surface is, for example, a ground surface, a roof, etc. In other words, the back surface is the surface of the back contact cell 100 provided with fingers.

Optionally, the staggered arrangement refers to that one second finger 121 is provided between two adjacent first fingers 111, and one first finger 111 is provided between two adjacent second fingers 121. Optionally, one of the first finger 111 and the second finger 121 is a positive finger, and the other of the first finger 111 and the second finger 121 is a negative finger.

Optionally, the back surface includes the current collection region 13 and the non-current collection region 14 which are distributed in a staggered manner. In other words, a non-current collection region 14 is formed between two adjacent current collection regions 13; and a current collection region 13 is formed between two adjacent non-current collection regions 14.

Optionally, an arrangement direction in which the current collection regions 13 and the non-current collection regions 14 are arranged alternately is perpendicular to an arrangement direction in which the first fingers 111 and the second fingers 121 are arranged alternately. It can be understood that, in other embodiments, an arrangement direction in which the current collection regions 13 and the non-current collection regions 14 are arranged alternately and an arrangement direction in which the first fingers 111 and the second fingers 121 are arranged alternately may also be an angle, which is not limited herein.

Optionally, the current collection region 13 has two types of polarity, which are respectively a first current collection region and a second current collection region, the first current collection region and the second current collection region being distributed in a staggered manner. In other words, a second current collection region is formed between two adjacent first current collection regions, and a first current collection region is formed between two adjacent second current collection regions. Optionally, one of the first current collection region and the second current collection region is a positive current collection region, and the other one of the first current collection region and the second current collection region is a negative current collection region.

Optionally, an arrangement direction in which the first current collection region and the second current collection region are arranged alternately is perpendicular to an arrangement direction in which the first fingers 111 and the second fingers 121 are arranged alternately. It can be understood that, in other embodiments, an arrangement direction in which the first current collection region and the second current collection region are arranged alternately and an arrangement direction in which the first fingers 111 and the second fingers 121 are arranged alternately may also be an angle, which is not limited herein.

In the examples of Figs. 1, 2 and 3, a first busbar 112 and a second busbar 122 are respectively formed in the first current collection region and the second current collection region. In other words, in the examples of Figs. 1, 2, and 3, the currents of the fingers of the same polarity are collected by the busbars of the same polarity. Optionally, one of the first busbar 112 and the second busbar 122 is a positive busbar, and the other of the first busbar 112 and the second busbar 122 is a negative busbar.

It can be understood that, in other embodiments, the first current collection region and the second current collection region may be provided with a first interconnector and a second interconnector, respectively. That is, the currents of the fingers of the same polarity are collected by the interconnectors of the same polarity. In other embodiments, it may be that the current of part of the collection region 13 is collected by the busbar, and the current of the rest of the current collection region 13 is collected by the interconnector. The specific manner of collecting the current of the fingers is not limited herein.

The interconnector is an electric conductor that connects the back contact cells 100 in series to form a cell string. The interconnector is, for example, a conductive wire, a conductive sheet, or a conductive plate. In this description, the interconnector is taken as an example for description, but this does not represent a limitation to the interconnector.

Please refer to Figs. 1 and 3, the first insulation members 21 are arranged at the edges of the non-current collection regions 14 in a continuous manner in the extension direction of the current collection regions 13, and cover portions of the fingers located in the non-current collection regions 14 close to the current collection regions 13. In this way, the part of the finger close to the current collection region 13, whether having the same polarity as or opposite to that of the current collection region 13, is covered with the first insulation members 21, thereby minimizing the risk of a short circuit of the back contact cell 100. Furthermore, when the first insulation members 21 are provided, it is unnecessary to consider the polarities of the fingers and the current collection regions 13, which facilitates improving the efficiency of providing the first insulation members 21. Furthermore, the first insulation members 21 cover continuously, without the need of avoiding fingers having the same polarity as that of the current collection region 13, and the process for providing the first insulation members 21 is simpler, which is also beneficial to improving the efficiency of providing the first insulation members 21.

As state above, the current collection regions 13 and the non-current collection regions 14 are distributed in a staggered manner. Therefore, the term "edge" in the expression "the first insulation members 21 are arranged at the edges of the non-current collection regions 14 in a continuous manner in the extension direction of the current collection regions 13" refers to that the first insulation members 21 are provided at the edge of the non-current collection region 14 close to the current collection region 13. The "extending direction" in the expression "the first insulation members 21 are arranged at the edges of the non-current collection regions 14 in a continuous manner in the extension direction of the current collection regions 13" refers to the direction of the boundary line between the non-current collection region 14 and the current collection region 13. The expression "arranged continuously" in the expression "the first insulation members 21 are arranged at the edges of the non-current collection regions 14 in a continuous manner in the extension direction of the current collection regions 13" refers to that the first insulation members 21 are not disconnected.

In other words, the first insulation members 21 are provided continuously at the edges of the non-current collection regions 14 close to the current collection regions 13 in the direction of the boundary line between the non-current collection region 14 and the current collection region 13.

Please refer to Figs. 1 and 3, the first insulation member 21 covers the part of the finger located in the non-current collection region 14 close to the current collection region 13, and covers the fingers having two polarities. It can be understood that, in other embodiments, at the edge of the non-current collection region 14 close to the current collection region 13, only fingers having the same polarity as the current collection region 13 are formed, and fingers having a polarity opposite to the current collection region 13 are not formed, so that the first insulation member 21 covers a part of the finger located at the non-current collection region 14 close to the current collection region 13, and covers such fingers having the same polarity as the current collection region 13. The specific polarity and the number of polarities of the fingers covered with the first insulation members 21 are not limited herein.

Please refer to Figs. 1 and 3, an outer edge of the first insulation member 21 is a straight line or a polygonal line. It should be understood that, in other embodiments, the outer edge of the first insulation member 21 may also be a curve. The specific form of the outer edge of the first insulation member 21 is not limited herein.

### Embodiment 2

In some optional embodiments, the thickness of the first insulation member 21 is 10µm-50µm, for example, 10µm, 12µm, 15µm, 17µm, 20µm, 25µm, 28µm, 30µm, 35µm, 40µm, 42µm, 45µm, 49µm or 50µm.

In this way, the thickness of the first insulation member 21 is in an appropriate range, which can avoid a poor insulating effect caused by an excessively small thickness, and can also avoid material waste and increased cost caused by an excessively large thickness.

Preferably, the thickness of the first insulation member 21 is 20µm-30µm. In this way, the overall effect of insulation and saving is best.

It should be noted that the thickness of the first insulation member 21 may be a certain constant value within 10µm-50µm, and may also fluctuate within 10µm-50µm.

### Embodiment 3

Please refer to Fig. 3, in some optional embodiments, a width w of the first insulation member 21 at the edge of the non-current collection region 14 is 100µm-1000µm, for example, 100µm, 102µm, 110µm, 200µm, 250µm, 300µm, 400µm, 500µm, 600µm, 900µm, 990µm or 1000µm.

In this way, the width of the first insulation member 21 at the edge of the non-current collection region 14 is within an appropriate range, which can avoid a poor insulating effect caused by an excessively small width and a high risk of short circuit of the back contact cell 100, and can also avoid material waste and increased cost caused by an excessively large width.

Preferably, the width w of the first insulation member 21 at the edge of the non-current collection region 14 is 400µm-600µm. In this way, the overall effect of insulation and saving is best.

It should be noted that the width w of the first insulation member 21 at the edge of the non-current collection region 14 may be a certain constant value within 100µm-1000µm, and may also fluctuate within 100µm-1000µm.

### Embodiment 4

Please refer to Fig. 3, in some optional embodiments, busbars are formed on the back surface, and the busbar is provided in the current collection region 13 and is exposed from the first insulation member 21."Exposed" means that the orthographic projection of the busbas on the cell substrate does not overlap with the orthographic projection of the first insulation member on the cell substrate

**In** this way, the current of the finger is collected by the busbar, which is convenient to lead out the current of the back contact cell 100. Furthermore, the busbar is exposed from the first insulation member 21, and is not blocked by the first insulation member 21, so that it is convenient to connect to the interconnector to form a cell string.

Optionally, busbars having two polarities, which are distributed in a staggered manner and are respectively first busbars 112 and second busbars 122, are formed on the back surface; and the currents of fingers having two polarities, i. e. first fingers 111 and second fingers 121, are respectively collected. Optionally, the staggered arrangement refers to that one second busbar 122 is provided between two adjacent first busbars 112, and one first busbar 112 is provided between two adjacent second busbars 122. Optionally, one of the first busbar 112 and the second busbar 122 is a positive busbar, and the other of the first busbar 112 and the second busbar 122 is a negative busbar.

It can be understood that, in other embodiments, busbars having two polarities may also be formed on the back surface to respectively collect the current of the part of the fingers having the corresponding to polarity, and the current of the rest part of the fingers is collected by the interconnector; in other embodiments, busbars having one polarity may be formed on the back surface may to collect the current of the finger having that polarity, and the current of the fingers having the other polarity is collected by the intercollector. The specific form in which the current of fingers is collected by the busbars is not limited herein.

### Embodiment 5

Please refer to Fig. 1, in some optional embodiments, a ratio of the coverage area of the first insulation members 21 to the total area of the back contact cell 100 is 10% to 20%, for example, 10%, 11%, 15%, 18% or 20%.

In this way, the ratio of the coverage area of the first insulation members 21 to the total area of the back contact cell 100 is in an appropriate range, which can avoid a small coverage area of the first insulation members 21 and a high risk of short circuit of the back contact cell 100 caused by an excessively small ratio, and can also avoid material waste and increased cost caused by an excessively high ratio.

Preferably, the ratio of the coverage area of the first insulation members 21 to the total area of the back contact cell 100 is 15%. In this way, the overall effect of insulation and saving is best.

### Embodiment 6

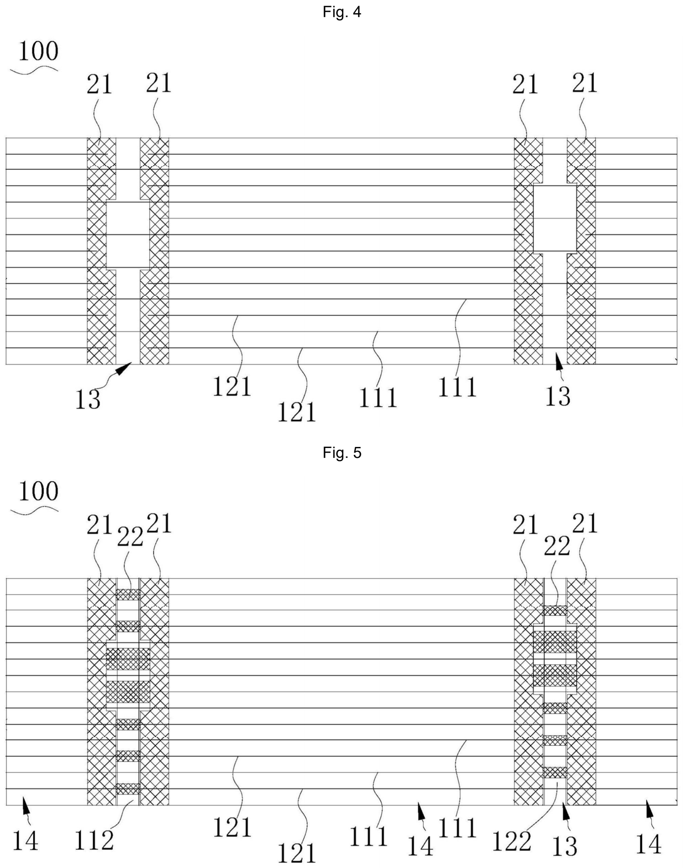

Please refer to Fig. 4, in some optional embodiments, a back contact cell 100 is a busbar-free cell; a part of each finger is located in the current collection region 13; the rest part of each finger is located in the non-current collection region 14; the current collection region 13 is used for providing an interconnector; and the current collection region 13 corresponding to each interconnector exposes fingers having the same polarity.

In this way, the back contact cell 100 does not have busbars, and the fingers is collected by the interconnector, so that the paste of the busbar can be saved, which is beneficial to reducing costs.

Optionally, the interconnector has two polarities to respectively collect the current of fingers having the same polarity.

Optionally, the interconnector is an electric conductor that connects the back contact cells 100 in series to form a cell string. The interconnector is, for example, a conductive wire, a conductive sheet, or a conductive plate. In this description, the interconnector is taken as an example for description, but this does not represent a limitation to the interconnector.

### Embodiment 7

Please refer to Fig. 4, in some optional embodiments, the current collection region 13 is provided with fingers having one polarity, and the current collection region 13 is entirely exposed from the first insulation member 21."Exposed" means that the orthographic projection of the current collection region on the cell substrate does not overlap with the orthographic projection of the first insulation member on the cell substrate.

In this way, the interconnector can be directly provided in the current collection region 13, without blocking fingers having a polarity different from that of the interconnector, thereby improving the production efficiency and reducing costs.

### Embodiment 8

Please refer to Fig. 5, in some optional embodiments, the current collection region 13 is provided with fingers having two polarities, the back contact cell 100 includes second insulation members 22, and the second insulation members 22 cover, in the current collection region 13, fingers having a polarity opposite to that of the corresponding interconnector.

In this way, fingers having one polarity can be blocked in the current collection region 13, and fingers having another polarity can be exposed to be connected to the interconnector for current collection, thereby reducing the risk of short circuit of the cell string.

Optionally, the second insulation members 22 completely cover, in the current collection region 13, the fingers having a polarity opposite to that of the corresponding interconnector. In this way, it is ensured that the fingers having a polarity opposite to that of the interconnector will not be exposed in the current collection region 13, thereby minimizing the risk of short circuit.

It can be understood that the interconnector itself does not have a polarity, but the finger to be collected by interconnector have a polarity, and therefore, the polarity of the interconnector refers to the polarity of the finger to be collected by interconnector.

### Embodiment 9

Please refer to Fig. 5, in some optional embodiments, a ratio of the sum of the coverage areas of the first insulation members 21 and the second insulation members 22 to the total area of the back contact cell 100 is 5% to 15%, for example, 5%, 6%, 8%, 10%, 11%, 13% or 15%.

In this way, the ratio of the sum of the coverage areas of the first insulation members 21 and the second insulation members 22 to the total area of the back contact cell 100 is in an appropriate range, which can avoid a small total coverage area of the first insulation members 21 and the second insulation members 22 and a high risk of short circuit of the back contact cell 100 caused by an excessively small ratio, and can also avoid material waste and increased cost caused by an excessively high ratio.

Preferably, the ratio of sum of the coverage areas of the first insulation members 21 and the second insulation members 22 to the total area of the back contact cell 100 is 10%. In this way, the overall effect of insulation and saving is best.

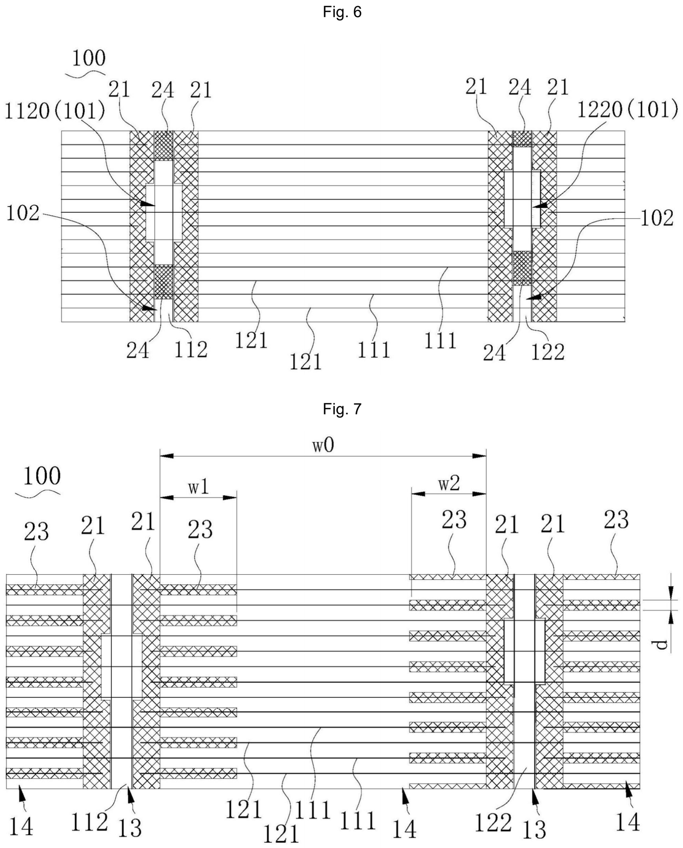

Please refer to Fig. 6, in some optional embodiments, an interconnector electrical connection region 101 and a non-interconnector electrical connection region 102 is formed on the cell substrate 10; the back contact cell 100 includes limiting members 24; the limiting members 24 are connected to the first insulation members 21 and surround the interconnector electrical connection region 101.

In this way, a conductive material can be prevented from flowing from the interconnector electrical connection region 101 to the fingers having a polarity different from that of the interconnector, thereby preventing the interconnector from conducting with the fingers having an opposite polarity, and reducing the risk of short circuit of the back contact cell 100. Furthermore, the conductive material can also be prevented from flowing from the interconnector electrical connection region 101 to the fingers having a polarity the same as that of the interconnector, thereby preventing the height of the conductive material from being relatively low, and avoiding poor connection.

Optionally, the interconnector electrical connection region 101 includes a first interconnector electrical connection region 1120 and a second interconnector electrical connection region 1220 which have opposite polarities. The first interconnector electrical connection region 1120 has the same polarity as the first finger 111, and the second interconnector electrical connection region 1220 has the same polarity as the second finger 121.

Optionally, the limiting member 24 may be an insulation member. In this way, the limiting member 24 can be insulated while limiting the position, thereby reducing the risk of short circuit.

In the example of Fig. 6, busbars are formed on the back surface of the cell substrate 10; an interconnector electrical connection region 101 and a non-interconnector electrical connection region 102 are formed on the busbar; and the interconnector electrical connection region 101 is a region where the busbar is electrically connected to the interconnector.

Optionally, the interconnector electrical connection region 101 includes a bonding pad region and/or a conductive adhesive region. Optionally, the bonding pad region may be provided with a conductive material. The conductive material is, for example, a solder such as a tin paste. Optionally, the conductive adhesive region may be provided with a conductive adhesive. In other words, the interconnector electrical connection region 101 of the busbar can be connected to the interconnector by means of welding, and can also be electrically bonded to the interconnector by means of a conductive adhesive; and the interconnector can also be connected by welding and by bonding of the conductive adhesive.

Optionally, the area of the interconnector electrical connection region 101 is 2 mm² to 6 mm², for example, 2 mm², 3 mm², 3.75 mm², 4 mm², 5 mm² or 6mm². In this way, the area of the interconnector electrical connection region 101 is in an appropriate range, which can avoid unstable connection between the back contact cell 100 and the interconnector caused by an excessively small area, and can also avoid waste of conductive materials and poor insulating effect caused by an excessively large area. Preferably, the interconnector electrical connection region 101 is rectangular, and has an area of 3.75 mm², a width of 1.5 mm and a length of 2.5 mm. **In** this way, the connection between the back contact cell 100 and the interconnector, the saving of the conductive material, and the insulation effect are all achieved, achieving the best overall effect.

Optionally, the number of the interconnector electrical connection regions 101 is 30 to 300, for example, 30, 40, 50, 100, 120, 150, 200, 280 or 300. In this way, the number of the interconnector electrical connection regions 101 is in an appropriate range, which can avoid unstable connection between the back contact cell 100 and the interconnectors caused by too less regions, and can also avoid low efficiency and high costs caused by too many regions.

It should be noted that the quantity range of 30 to 300 corresponds to the back contact cell 100 being a whole cell piece. It can be understood that, in cases where the back contact cell 100 is a half-cell, a one-third cell, or other proportionally divided cell obtained by splitting a whole cell piece, the number of the interconnector electrical connection regions 101 can be determined on the basis of the dividing ratio and the range of 30-300. For example, in cases where the back contact cell 100 is a half-cell divided from a whole cell piece, the number of interconnector electrical connection regions 101 is 15 to 150.

It should be understood that, in other examples, the back contact cell 100 may also be a busbar-free cell, the back surface of the back contact cell 100 includes interconnector electrical connection regions 101 and non-interconnector electrical connection regions 102, a part of each finger is located in the interconnector electrical connection regions 101, the other part of each finger is located in the non-interconnector electrical connection regions 102, and the interconnector electrical connection region 101 is a region where the finger is electrically connected to the interconnectors. In this way, the finger of the main-grid-less battery merges through the series connection. It can be understood that, regardless of whether the back contact cells 100 has busbars, the back contact cells are connected into a cell string by means of interconnectors; the limiting members 24, together with the first insulation members 21, can surround the interconnector electrical connection region 101, thereby preventing the conductive material from flowing from the interconnector electrical connection region 101 to the fingers having fingers having a polarity different from that of the interconnector.

Optionally, the width of the interconnector electrical connection region 101 may be greater than or equal to the spacing, at the non-interconnector electrical connection region 102, between the first insulation members 21 on two sides. In this way, the area of the interconnector electrical connection region 101 is larger, and more conductive materials can be provided, so that the connection between the back contact cell 100 and interconnectors such as the interconnectors is more stable. In other embodiments, the width of the interconnector electrical connection region 101 may also be less than the spacing, at the non-interconnector electrical connection region 102, between the first insulation members 21 on two sides.

Optionally, the area of the interconnector electrical connection region 101 is 0.02 mm² to 0.6 mm², for example, 0.02 mm², 0.03 mm², 0.375 mm², 0.4 mm², 0.5 mm² or 0.6mm². In this way, the area of the interconnector electrical connection region 101 is in an appropriate range, which can avoid unstable connection between the back contact cell 100 and the interconnector caused by an excessively small area, and can also avoid waste of conductive materials and poor insulating effect caused by an excessively large area. Preferably, the interconnector electrical connection region 101 is rectangular, and has an area of 0.375 mm², a width of 0.15 mm and a length of 0.25 mm. In this way, the connection between the back contact cell 100 and the interconnector, the saving of the conductive material, and the insulation effect are all achieved, achieving the best overall effect.

Optionally, the number of the interconnector electrical connection regions 101 is 1000 to 4000, for example, 1000, 1500, 2000, 2500, 3000, 3500, 3800 or 4000. In this way, the number of the interconnector electrical connection regions 101 is in an appropriate range, which can avoid unstable connection between the back contact cell 100 and the interconnectors caused by too few interconnectors, and can also avoid low efficiency and high cost caused by too many interconnectors.

It should be noted that the quantity range of 1000 to 4000 corresponds to the back contact cell 100 being a whole cell piece. It can be understood that, in cases where the back contact cell 100 is a half-cell, a one-third cell, or other proportionally divided cell obtained by splitting a whole cell piece, the number of the interconnector electrical connection regions 101 can be determined on the basis of the dividing ratio and the range of 1000-4000. For example, in cases where the back contact cell 100 is a half-cell divided from a whole cell piece, the number of interconnector electrical connection regions 101 is 500 to 2000.

### Embodiment 10

Please refer to Figs. 7, 8 and 9, in some optional embodiments, the back contact cell 100 includes third insulation members 23; and the third insulation members 23 are continuously provided in the non-current collection region 14, extending from the first insulation members 21 in the extension direction of the fingers, and at least partially covering the fingers having a polarity opposite to that of the corresponding current collection region 13.

In this way, the fingers covered with the third insulation members 23 can be prevented to be conducted with adjacent fingers having an opposite polarity by means of conductive foreign matters such as solder dross, thereby reducing the risk of short circuit of the back contact cell 100. Furthermore, even if the current collector is offset and contacts the fingers covered with the third insulation members 23, the current collector will not be conducted with the fingers which are covered with the third insulation members 23 and have an opposite polarity, thereby reducing the risk of short circuit of the back contact cell 100.

Optionally, "the extension direction of the fingers" refers to the length direction of the fingers. The expression "arranged continuously" means that the third insulation members 23 are not disconnected. In other words, the third insulation members 23 are arranged continuously in the non-current collection region 14, extending from the first insulating members 21 along the length direction of the fingers.

Optionally, "at least partially" refers to some or all. In other words, the third insulation members 23 cover, in the non-current collection region 14, some of the fingers having a polarity opposite to that of the corresponding current collection region 13, or all the fingers having a polarity opposite to that of the corresponding current collection region 13.

### Embodiment 11

Please refer to Figs. 7, 8 and 9, in some optional embodiments, a ratio of the sum of lengths of the third insulation members 23 corresponding to two adjacent fingers to the distance between the first insulation members 21 at the two ends of the non-current collection region 14 is less than or equal to 150%, for example, 150%, 145%, 140%, 100%, 90%, 50%, 10%, 5%, 1%, or 0.1%.

In this way, the ratio of the sum of lengths of the third insulation members 23 corresponding to two adjacent fingers to the distance between the first insulation members 21 at the two ends of the non-current collection region 14 is in an appropriate range, which can reduce the risk of short circuit, and avoid material waste and increased cost caused by an excessive large ratio. In this way, the risk of short circuit is reduced, and the cost is reduced.

It can be understood that, since the third insulation member 23 must have a certain length, a ratio of the sum of the lengths of the third insulation members 23 corresponding to two adjacent fingers to the length of the non-current collection region 14 is greater than 0.

Optionally, the length of the third insulation member 23 refers to the dimension of the third insulation member 23 in the length direction of the finger.

Optionally, the spacing between the first insulation members 21 at the two ends of the non-current collection region 14 refers to a distance, in the length direction of the finger, between two adjacent boundary lines of the first insulation members 21 at the two ends of the non-current collection region 14.

For example, in the example of Fig. 7, the lengths of the third insulation members 23 corresponding to two adjacent fingers are w1 and w2, respectively, the spacing between the first insulation members 21 at two ends of the non-current collection region 14 is w0, then the ratio (w1 + w2)/w0 is less than or equal to 150%.

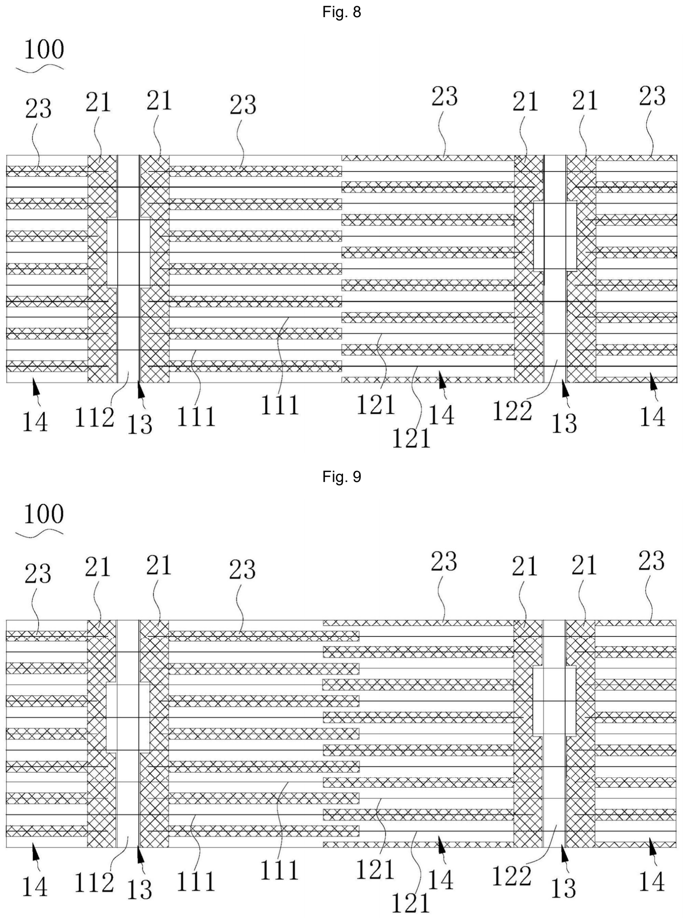

In the example of Fig. 7, the ratio of the sum of lengths of the third insulation members 23 corresponding to two adjacent fingers to the spacing between the first insulation members 21 at the two ends of the non-current collection region 14 is 50%. In the example of Fig. 8, the ratio of the sum of lengths of the third insulation members 23 corresponding to two adjacent fingers to the spacing between the first insulation members 21 at the two ends of the non-current collection region 14 is 100%. In the example of Fig. 9, the ratio of the sum of lengths of the third insulation members 23 corresponding to two adjacent fingers to the spacing between the first insulation members 21 at the two ends of the non-current collection region 14 is 110%. Here is only an example, and does not represent a limitation on the specific ratio.

Optionally, in the examples of Figs. 7, 8 and 9, the lengths of the third insulation members 23 corresponding to two adjacent fingers are the same. It can be understood that, in other examples, the lengths of the third insulation members 23 corresponding to two adjacent fingers may be different.

Please refer to Figs. 8 and 9, in some optional embodiments, in the non-current collection region 14, the third insulation members 23 covering two adjacent fingers are continuously distributed. In this way, two adjacent fingers having opposite polarities can be prevented from being conducted by means of conductive foreign matters such as solder dross, thereby ensuring the normal operation of the back contact cell 100 and reducing the risk of short circuit of the back contact cell 100.

Optionally, the third insulation members 23 covering two adjacent fingers being continuously distributed means that the third insulation members 23 covering two adjacent fingers are continuously distributed in the length direction of the fingers. In other words, the projection, on an adjacent finger and in the width direction of the finger, of a region, which is not covered with the third insulation element 23, on one finger overlaps with a region, which is covered with the third insulation element 23, on the adjacent finger, or the projection, on an adjacent finger and in the width direction of the finger, of a region, which is not covered with the third insulation element 23, on one finger is located within a region, which is covered with the third insulation element 23, on the adjacent finger.

It can be understood that, in other embodiments, the third insulation members 23 covering two adjacent fingers being continuously distributed also means that the third insulation members 23 covering two adjacent fingers are continuously arranged in a width direction of the finger; in other embodiments, the third insulation members 23 covering two adjacent fingers being continuously distributed also means that the third insulation members 23 covering two adjacent fingers are continuously arranged in a direction other than the length direction and the width direction of the finger. The specific direction in which the third insulation members 23 covering two adjacent fingers are continuously distributed is not limited herein.

Please refer to Fig. 8, in some optional embodiments, the edges of third insulation members 23 covering two adjacent fingers are aligned at the continuous joint.

In this way, the third insulation members 23 covering two adjacent fingers are just continuous in the width direction of the fingers, so that the coverage area of the third insulation members 23 can be reduced, and the cost can be reduced.

Optionally, each third insulation member 23 includes a first side and a second side, the first side is a side of the third insulation member 23 extending along the finger, and the second side is a side adjacent to the first side. For example, in Fig. 3, the third insulation member 23 is rectangular, with the long side being the first side and the short side being the second side. It should be understood that, in other embodiments, the third insulation member 23 may also be a parallelogram or other shapes.

Optionally, two adjacent third insulation members 23 are located at two first sides between two adjacent fingers, and a connecting line at an endpoint of a continuous joint is perpendicular to a length direction of the finger. In this way, it is ensured that the third insulation members 23 covering two adjacent fingers are continuous exactly, thereby reducing the risk of short circuit.

Optionally, two second sides of two adjacent fingers at the continuous joint are located on the same straight line. In this way, it is ensured that the third insulation members 23 covering two adjacent fingers are continuous exactly, thereby reducing the risk of short circuit. In other embodiments, two second sides of two adjacent fingers at the continuous joint may not be located on the same straight line.

Please refer to Fig. 9, in some optional embodiments, the edges of third insulation members 23 covering two adjacent fingers are staggered at the continuous joint.

In this way, the third insulation members 23 covering two adjacent fingers partially overlap in the width direction of the fingers, thereby reducing the risk of short circuit.

Optionally, each third insulation member 23 includes a first side and a second side, the first side is a side of the third insulation member 23 extending along the finger, and the second side is a side adjacent to the first side. For example, in Fig. 4, the third insulation member 23 is rectangular, with the long side being the first side and the short side being the second side. It should be understood that, in other embodiments, the third insulation member 23 may also be a parallelogram or other shapes.

Optionally, the projection, on the adjacent finger and in the widthwise direction of the finger, of the second side of the third insulation member 23 covering the finger is located within the region, covering the third insulation member 23, on the adjacent finger. In this way, it is ensured that the third insulation members 23 covering two adjacent fingers are staggered, thereby reducing the risk of short circuit.

Please refer to Figs. 8 and 9, in some optional embodiments, the third insulation members 23 covering two adjacent fingers have the same length. It can be understood that, in other optional embodiments, the lengths of the third insulation members 23 covering two adjacent fingers are different. It is not limited herein.

### Embodiment 12

Please refer to Figs. 8 and 9, in some optional embodiments, a ratio of the sum of lengths of the third insulation members 23 corresponding to two adjacent fingers to the distance between the first insulation members 21 at the two ends of the non-current collection region 14 is greater than or equal to 100% and less than or equal to 120%, for example, 100%, 105%, 110%, 112%, 115%, 118% or 120%.

In this way, the ratio of the sum of lengths of the third insulation members 23 corresponding to two adjacent fingers to the distance between the first insulation members 21 at the two ends of the non-current collection region 14 is in an appropriate range, which further reduces the risk of short circuit, and has a better overall effect of preventing short circuit and reducing costs.

### Embodiment 13

Please refer to Fig. 7, in some optional embodiments, the width d of the third insulation member 23 is 50µm to 500µm, for example, 50µm, 55µm, 80µm, 100µm, 200µm, 250µm, 300µm, 400µm, or 500µm.

In this way, the width of the third insulation member 23 is within an appropriate range, which can avoid difficulty in covering the finger and poor insulation effect due to an excessively small width, and can also avoid material waste and increased cost caused by an excessively large width.

Preferably, the width d of the third insulation member 23 is 200µm to 300µm. In this way, the insulation effect and the cost are both achieved, and the overall effect is the best.

It should be noted that the width of the third insulation member 23 may be a certain constant value within 50µm to 500µm, and may also fluctuate within 50µm to 500µm.

### Embodiment 14

Please refer to Fig. 7, in some optional embodiments, the difference between the width of the third insulation member 23 and the width of the corresponding finger is 20µm to 200µm, for example, 20µm, 25µm, 30µm, 50µm, 80µm, 100µm, 150µm, 180µm, or 200µm.

In this way, the difference between the width of the third insulation member 23 and the width of the corresponding finger is within an appropriate range, which can avoid difficulty in covering the finger and poor insulating effect caused by too small difference between the width of the third insulation member 23 and the width of the corresponding finger, and can also avoid material waste and increased cost caused by too large difference between the width of the third insulation member 23 and the width of the corresponding finger.

Preferably, the difference between the width of the third insulation member 23 and the width of the corresponding finger is 100 µm to 150 µm. In this way, the insulation effect and the cost are both achieved, and the overall effect is the best.

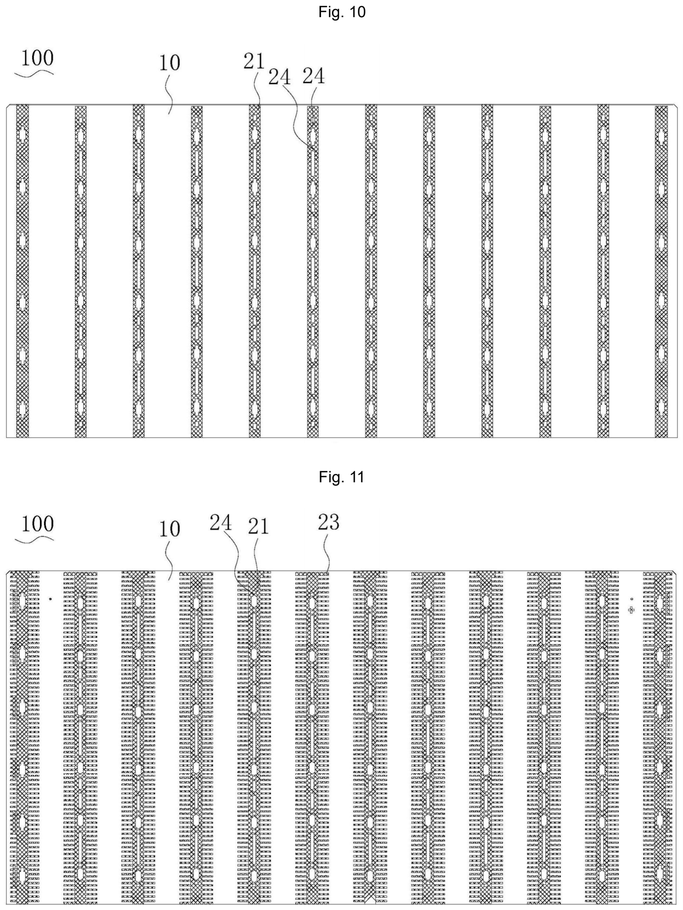

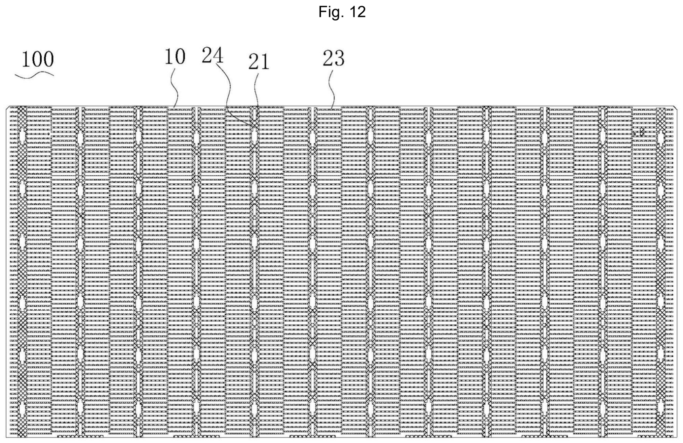

Referring to Figs. 10, 11 and 12, the specific features, structures, materials, or characteristics of the back contact cells 100 described herein may be combined in any suitable manner in one or more embodiments or examples. For example, in Fig. 10, the back contact cell 100 includes cell substrate 10, first insulation members 21, and limiting members 24. As another example, in Figs. 11 and 12, the back contact cell 100 includes cell substrate 10, first insulation members 21, third insulation members 23, and limiting members 24. For another example, in Fig. 11, a ratio of the sum of the lengths of the third insulation members 23 corresponding to two adjacent fingers to the length of the non-current collection region 14 is 50%. In Fig. 12, a ratio of the sum of the lengths of the third insulation members 23 corresponding to two adjacent fingers to the length of the non-current collection region 14 is 100%.

In an example, referring to Fig. 10, the insulating pattern of Fig. 10 is printed on the cell substrate 10, and the insulation adhesive is cured using a heat curing process, where the weight of the cured insulation adhesive is 0.28 g, and the series short-circuit ratio is 0.51%. Obviously, the risk of short circuit of the back contact cell 100 can be reduced.

In an example, referring to Fig. 11, the insulating pattern of Fig. 11 is printed on the cell substrate 10, and the insulation adhesive is cured using a heat curing process, where the weight of the cured insulation adhesive is 0.45 g, and the series short-circuit ratio is 0.2%. Obviously, the risk of short circuit of the back contact cell 100 can be reduced.

In an example, referring to Fig. 12, the insulating pattern of Fig. 12 is printed on the cell substrate 10, and the insulation adhesive is cured using a heat curing process, where the weight of the cured insulation adhesive is 0.65 g, and the series short-circuit ratio is 0.12%. Obviously, the risk of short circuit of the back contact cell 100 can be reduced.

It should be noted that the data of the described three examples is based on the back contact cell 100 being a whole cell piece.

### Embodiment 15

In some optional embodiments, the first insulation member 21 is a transparent insulation member.

In this way, shielding of the first insulation member 21 from the sunlight can be reduced, so that more sunlight is absorbed by the back contact cell 100, which is beneficial to improving the photoelectric conversion efficiency.

It should be noted that being transparent means that the light transmittance of the first insulation member 21 at a thickness of 20 micrometres to visible light is greater than or equal to 70%.

It should be appreciated that, in other embodiments, the first insulation member 21 may be a non-transparent insulation member. It is not limited herein.

Optionally, the second insulation member 22 is a transparent insulation member. In this way, shielding of sunlight by the insulation member can be further reduced, and the photoelectric conversion efficiency can be further improved.

Optionally, the third insulation element 23 is a transparent insulation element. In this way, shielding of sunlight by the insulation member can be further reduced, and the photoelectric conversion efficiency can be further improved.

It should be noted that the explanation and description of the second insulation member 22 and the third insulation member 23 are similar to those of the first insulation member 21, and reference may be made to the related content of the first insulation member 21, which is not repeated herein.

### Embodiment 16

In some optional embodiments, the first insulation member 21 is a transparent fluorescent insulation member.

In this way, the first insulation member 21 emits light under the irradiation of a light source with the corresponding wavelength, thereby facilitating the detection of the position of the first insulation member 21, and improving the accuracy of providing the first insulation member 21 on the back contact cell 100.

In the present embodiment, the second insulation member 22 is a transparent fluorescent insulation member. In this way, the second insulation member 22 emits light under the irradiation of the light source with the corresponding wavelength, thereby facilitating the detection of the position of the second insulation member 22, and improving the accuracy of providing the second insulation member 22 on the back contact cell 100.

In the present embodiment, the third insulation member 23 is a transparent fluorescent insulation member. In this way, the third insulation member 23 emits light under the irradiation of the light source with the corresponding wavelength, thereby facilitating the detection of the position of the third insulation member 23, and improving the accuracy of providing the third insulation member 23 on the back contact cell 100.

It should be noted that the explanation and description of the second insulation member 22 and the third insulation member 23 are similar to those of the first insulation member 21, and reference may be made to the related content of the first insulation member 21, which is not repeated herein.

### Embodiment 17

In some optional embodiments, the transparent fluorescent insulation member is made of a transparent insulation adhesive, and the transparent insulation adhesive includes: a resin component with a mass percentage of 60-80%; an inorganic filler with a mass percentage of 5-15%; a curing agent with a mass percentage of 5-15%; a solvent with a mass percentage of less than 10%; and a fluorescent agent with a mass percentage of greater than or equal to 0.1% and less than 1%.

In this way, as the insulation adhesive is a transparent insulation member, shielding against the sunlight can be reduced, so that more sunlight is absorbed by the back contact cell 100, which facilitates improving the photoelectric conversion efficiency. Furthermore, since the transparent insulation adhesive includes a fluorescent agent with a mass percentage of greater than or equal to 0.1 % and less than 1%, the transparent insulation adhesive emits light under the irradiation of the light source with the corresponding wavelength, thereby facilitating the detection of the position of the transparent insulation adhesive, and improving the accuracy of providing the transparent insulation adhesive on the back contact cell 100.

Optionally, the transparent insulation adhesive may be provided on the back contact cell 100 by screen printing, jet valve, coating, etc.

Optionally, the proportion of the coverage area of the transparent insulation adhesive on the back contact cell 100 is greater than 10%.

Optionally, the mass percentage of the resin component is, for example, 60%, 62%, 65%, 70%, 73%, 75%, 78% or 80%. In this way, the mass percentage of the resin component is within an appropriate range, which can reduce the brittleness of the insulation member formed by curing the insulation adhesive, and improve the bending resistance and impact resistance of the insulation member.

Optionally, the mass percentage of the inorganic filler is, for example, 5%, 6%, 8%, 10%, 11%, 14% or 15%. In this way, the relatively cheap inorganic filler can be used to reduce the amount of the resin component, thereby reducing the cost of the transparent insulation adhesive. Furthermore, the inorganic filler can enhance the mechanical property of the transparent insulation adhesive, making it easier to provided and adhere.

Optionally, the mass percentage of the curing agent is, for example, 5%, 8%, 10%, 11%, 14% or 15%. In this way, the transparent insulation adhesive can be cured within a predetermined process time.

Optionally, the mass percentage of the solvent is, for example, 9.99%, 9%, 7%, 5%, 4%, 2% or 0.1%. In this way, other materials in the transparent insulation adhesive can be dissolved, and the viscosity of the transparent insulation adhesive can be adjusted.

Optionally, the mass percentage of the fluorescent agent is, for example, 0.99%, 0.95%, 0.8%, 0.6%, 0.5%, 0.3% or 0.1%. The fluorescent agent causes whitening, and a mass percentage of greater than or equal to 1% will affect the light transmittance of the transparent insulation adhesive itself. In addition, the mass percentage of the fluorescent agent is greater than or equal to 0.1% and less than 1%, so that the light transmittance of the insulation adhesive itself is good, which facilitates ensuring the photoelectric conversion efficiency. Furthermore, the mass percentage of the fluorescent agent is greater than or equal to 0.1% and less than 1%, which will not cause an excessive cost, and is beneficial to ensuring normal operation of the solar cell and reducing the cost of the back contact cell 100 while ensuring that the insulation adhesive can be detected.

In some optional embodiments, the resin component includes at least one of modified polyacrylate, modified polyurethane, modified polyamide, modified polyester amide, modified polycarbonate, modified silicone ester, modified styrene ester, polystyrene, polytetrafluoroethylene, polyoxymethylene, modified phenolic resin, modified polyester, modified polyamide resin, and modified epoxy resin. In this way, various forms of resin components are provided, which can adapt to more practical production scenarios and practical production requirements, and is beneficial to improving the production efficiency of the transparent insulation adhesive. Furthermore, the resin component can reduce the brittleness of the insulation member formed by curing the transparent insulation adhesive, and improve the bending resistance and impact resistance of the insulation member.

In some optional embodiments, the inorganic filler includes talc powder. In this way, the relatively cheap talc powder can be used to reduce the amount of the resin component, thereby reducing the cost of the transparent insulation adhesive. Furthermore, the talc powder can enhance the thermal stability and corrosion resistance of the transparent insulation adhesive, so that the quality of the transparent insulation adhesive is better. In addition, the talc powder has an insulating property, and can improve the insulating property of the transparent insulation adhesive.

In some optional embodiments, the talc powder includes at least one of barium sulfate, calcium carbonate, and titanium dioxide. In this way, various forms of talc powder are provided, which can adapt to more practical production scenarios and practical production requirements, and is beneficial to improving the production efficiency of the transparent insulation adhesive.

In some optional embodiments, the curing agent includes an imidazole derivative. In this way, by using the imidazole derivative as a curing agent, the speed of curing the insulation adhesive can be increased, and the curing cost can be reduced.

In some optional embodiments, the imidazole derivative includes at least one of aliphatic amines, aromatics, and anhydride curing agents. In this way, various forms of curing agent are provided, which can adapt to more practical production scenarios and practical production requirements, and is beneficial to improving the production efficiency of the transparent insulation adhesive. Optionally, the aliphatic amine includes ethylenediamine and/or xylylenediamine. For example, the aliphatic amine includes ethylenediamine; for another example, the aliphatic amine includes xylylenediamine; for yet another example, the aliphatic amine includes both ethylenediamine and xylylenediamine. Optionally, the aromatic includes m-phenylenediamine and/or diaminodiphenylmethane. For example, the aromatic includes m-phenylenediamine; for another example, the aromatic includes diaminodiphenylmethane; for yet another example, the aromatic includes both m-phenylenediamine and diaminodiphenylmethane. Optionally, the anhydride curing agent includes phthalic anhydride and/or hexahydrophthalic anhydride. For example, the anhydride curing agent includes phthalic anhydride; for another example, the anhydride curing agent includes hexahydrophthalic anhydride; for yet another example, the anhydride curing agent includes both phthalic anhydride and hexahydrophthalic anhydride.

In some optional embodiments, the solvent includes at least one of dimethyl adipate, dimethyl succinate, dimethyl glutarate, dimethyl malonate, diethyl adipate, diethyl succinate, diethyl glutarate, dibutyl succinate, dibutyl glutarate, DBE, DBE-3, DBE-4, DBE-6, DBE-9, DBE-IB, and DBE-ME. In this way, the dibasic acid ester can better have the effect of dissolving, can react with the resin component to form a chain or cyclic polymer, and forms a stable solid compound after volatilization. Furthermore, various forms of dibasic acid ester are provided, which can adapt to more practical production scenarios and practical production requirements, and is beneficial to improving the production efficiency of the insulation adhesive.

### Embodiment 18

In some optional embodiments, the fluorescent agent includes at least one of fluorescent brightener OB-1, fluorescent brightener OB, aluminum oxide, zinc oxide, zinc sulfide, calcium sulfide, strontium sulfide, strontium aluminate, calcium chlorate, barium aluminate, rare earth fluorescent materials, fluorescent brightener BC, fluorescent brightener JD-3, fluorescent brightener BR, fluorescent brightener EBF, fluorescent brightener R, fluorescent brightener ER, 1,8-naphthalimide fluorescent compounds, polybenzene, polythiophene, polyfluorene, polytriphenylamine, polytriphenylamine derivatives, polycarbazole, polypyrrole, polymeric porphyrin and its derivatives, copolymers, N,N-dimethylaminobenzylidene dinitrile compounds, 8-hydroxyquinoline aluminum, and europium metal complexes.

In this way, various forms of fluorescent agent are provided, which can adapt to more practical production scenarios and practical production requirements, and is beneficial to improving the production efficiency of the transparent insulation adhesive.

Optionally, the rare earth fluorescent material refers to a fluorescent material containing rare-earth elements, i.e. a fluorescent material containing at least one rare-earth element of europium, samarium, erbium, and neodymium.

In one example, the fluorescent agent is a fluorescent brightener OB-1. When ultraviolet light is used to irradiate the insulation adhesive in which the fluorescent agent is the fluorescent brightener OB-1, the visible fluorescence color is blue, with a strong visual effect.

In the table below, the resin component, the curing agent and the solvent of the transparent insulation adhesive are respectively: 70% of a phenolic epoxy resin, 10% of an imidazole derivative and 5% of anisole. The fluorescent agents are all fluorescent brightener OB-1, and the inorganic fillers are all barium sulfate. The mass percentages of OB-1 and barium sulfate are shown in the following table.

The following table shows the fluorescence grayscale value, viscosity value and light transmittance of the transparent insulation adhesive corresponding to different addition amounts of fluorescent brightener OB-1 at a thickness of 20 micrometres. It is understood that the fluorescence grayscale value may characterize the fluorescence effect. The viscosity value can characterize printability, with the best printability achieved when the viscosity value is between 150 dPa·s to 250 dPa·s. Obviously, in cases where the mass percentage of the fluorescent agent is greater than or equal to 1%, although the transparent insulation adhesive has a strong fluorescent effect, both the printability and the light transmittance are poor. In cases where the mass percentage of the fluorescent agent is greater than or equal to 0.1% and less than 1%, the fluorescence of the transparent insulation adhesive is sufficient to be detected, and both the printability and the light transmittance are good. Therefore, the mass percentage of the fluorescent agent is greater than or equal to 0.1% and less than 1%, so that the detectability can be ensured, the fluorescent effect can be ensured, and the printability can be ensured, so that the overall effect of the transparent insulation adhesive is better.

| Mass percentage of fluorescent brightener OB-1 | Mass percentage of barium sulfate | Fluorescence grayscale value | Viscosity value (dPa·s) | Transmittance |
|---|---|---|---|---|
| 0.10% | 14.9% | 200 | 150 | 85-90% |
| 0.30% | 14.7% | 240 | 180 | 85-90% |
| 0.60% | 14.4% | 260 | 200 | 85-90% |
| 0.90% | 14.1% | 270 | 250 | 85-90% |
| 1% | 14% | 280 | 300 | 80-85% |
| 2% | 2% | 290 | 350 | 80-85% |
| 5% | 5% | 210 | 380 | 70-80% |

In another example, the fluorescent agent is aluminium oxide. When ultraviolet light is used to irradiate the insulation adhesive in which the fluorescent agent is aluminium oxide, the visual fluorescent color is wathet blue, and the visual effect is strong.

In the table below, the resin component, the curing agent and the solvent of the transparent insulation adhesive are respectively: 70% of a phenolic epoxy resin, 10% of an imidazole derivative and 5% of anisole. The fluorescent agents are all aluminium oxide, and the inorganic fillers are all barium sulphate. The mass percentages of aluminium oxide and barium sulfate are shown in the following table.

The following table shows the fluorescence grayscale value, viscosity value and light transmittance of the transparent insulation adhesive corresponding to different addition amounts of aluminium oxide at a thickness of 20 micrometres. Obviously, in cases where the mass percentage of the fluorescent agent is greater than or equal to 1%, although the transparent insulation adhesive has a strong fluorescent effect, both the printability and the light transmittance are poor. In cases where the mass percentage of the fluorescent agent is greater than or equal to 0.1% and less than 1%, the fluorescence of the transparent insulation adhesive is sufficient to be detected, and both the printability and the light transmittance are good. Therefore, the mass percentage of the fluorescent agent is greater than or equal to 0.1% and less than 1%, so that the detectability can be ensured, the fluorescent effect can be ensured, and the printability can be ensured, so that the overall effect of the transparent insulation adhesive is better.

| Fluorescent agent | Mass percentage | Fluorescence grayscale value | Viscosity value (dPa·s) | Transmittance |
|---|---|---|---|---|
| Aluminium oxide | 0.10% | 100 | 150 | 85-90% |
| Aluminium oxide | 0.5% | 150 | 180 | 85-90% |
| Aluminium oxide | 1% | 180 | 300 | 80-85% |
| Aluminium oxide | 5% | 200 | 380 | 70-80% |

Please note that specific data for the fluorescent agent being fluorescent brightener OB-1 and specific data for the fluorescent agent being aluminum oxide are provided herein. The other fluorescent agents are for example, fluorescent brightener-OB, fluorescent brightener OB, zinc oxide, zinc sulfide, calcium sulfide, strontium sulfide, strontium aluminate, calcium chlorate, barium aluminate, rare earth fluorescent materials, fluorescent brightener BC, fluorescent brightener JD-3, fluorescent brightener BR, fluorescent brightener EBF, fluorescent brightener R, fluorescent brightener ER, 1,8-naphthalimide fluorescent compounds, polybenzene, polythiophene, polyfluorene, polytriphenylamine, polytriphenylamine derivatives, polycarbazole, polypyrrole, polymeric porphyrin and its derivatives, copolymers, N,N-dimethylaminobenzylidene dinitrile compounds, 8-hydroxyquinoline aluminum, and europium metal complexes, where when the mass percentage is equal to or greater than 0.1% and less than 1%, the range of grayscale value characterizing the fluorescent effect is 100-300, and the range of viscosity value characterizing the printability is 150-300, and the light transmittance is in the range of 85-90%. To avoid redundancy, the details will not be repeated herein again.

In other embodiments, the fluorescent agent can include fluorescent brightener-OB; in other embodiments, the fluorescent agent can include barium aluminate, rare-earth fluorescent materials, fluorescent brightener BC, fluorescent brightener JD-3; in other embodiments, the fluorescent agent may include fluorescent brightener-EBF, fluorescent brightener R, fluorescent brightener ER, and 1,8-naphthalimide fluorescent compound. The specific form of the fluorescent agent is not limited herein.

Optionally, at least one light of green light, blue light, infrared light, ultraviolet light and white light can be used to irradiate the back contact cell 100, so that the insulation member formed by curing the transparent insulation adhesive emits fluorescence, thereby accurately detecting the position of the transparent insulation adhesive.

### Embodiment 19

The solar module of the embodiments of the present application includes the back contact cell 100 of any one of embodiments 1 to 18.

In this way, in the back contact cell 100 of the embodiment of the present application, since the first insulation members 21 are continuously arranged at the edge of the non-current collection region 14 in the extension direction of the current collection region 13, covering the portions of the fingers located in the non-current collection region 14 close to the current collection region 13, it prevents, at the edge of the non-current collection region 14 close to the current collection region 13, the fingers from being in conduct with current collectors of an opposite polarity, thereby ensuring the normal operation of the back contact cell 100 and reducing the risk of short circuit of the back contact cell 100.

In the present embodiment, the plurality of back contact cells 100 in the solar module may be connected in series sequentially to form a cell string, thereby enabling series current collection and output, for example, the series connection of the cells can be achieved using interconnectors (bus bars, interconnect strips), or a conductive back plate.

It should be understood that, in such a utility model, the solar module may further include a metal frame, a back plate, photovoltaic glass, and an adhesive film. The adhesive film may be filled between the front surface and the back surface of the back contact cell 100 and the photovoltaic glass, adjacent cells, etc.; as a filler, the adhesive film may be a transparent colloid having good light transmission and aging resistance, for example, the adhesive film may be an EVA adhesive film or a POE adhesive film, which may be selected according to actual situations, and is not limited herein.

The photovoltaic glass may cover the adhesive film on the front surface of the back contact cell 100; the photovoltaic glass may be ultra-clear glass which has high light transmittance and high transparency, and has excellent physical, mechanical and optical properties; for example, the light transmittance of the ultra-clear glass may be up to 92% or more, and can protect the back contact cell 100 without affecting the efficiency of the back contact cell 100 as far as possible. In addition, the adhesive film may bond the photovoltaic glass and the back contact cell 100 together, and the presence of the adhesive film may provide sealing, insulation, and waterproofing and moisture resistance for the back contact cell 100.

The back plate can be attached to the adhesive film on the back surface of the back contact cell 100; the back plate can protect and support the back contact cell 100, and provide reliable insulation, water resistance and aging resistance; the back plate can have multiple choices, and can generally be tempered glass, organic glass, a TPT composite adhesive film of aluminum alloy, etc., and can be specifically set according to specific situations, which is not limited herein. The entirety composed of the back plate, the back contact cell 100, the adhesive film and the photovoltaic glass can be provided on a metal frame; and the metal frame serves as a main external support structure of the whole solar module, and can stably support and mount the solar module, for example, by means of the metal frame, the solar module can be mounted at a position required to be mounted.

### Embodiment 20

The photovoltaic system of an embodiment of the present application includes the solar module of embodiment nineteen.

In this way, in the back contact cell 100 of the embodiment of the present application, since the first insulation members 21 are continuously arranged at the edge of the non-current collection region 14 in the extension direction of the current collection region 13, covering the portions of the fingers located in the non-current collection region 14 close to the current collection region 13, it prevents, at the edge of the non-current collection region 14 close to the current collection region 13, the fingers from being in conduct with current collectors of an opposite polarity, thereby ensuring the normal operation of the back contact cell 100 and reducing the risk of short circuit of the back contact cell 100.

In the present embodiment, the photovoltaic system may be applied in a photovoltaic power plant, such as a surface power station, a rooftop power plant and a floating power plant, and may also be applied to a device or an apparatus that generates power using solar energy, such as a solar power source, a solar street lamp, a solar-powered vehicle, and a solar building. Certainly, it can be understood that, the application scenarios of the photovoltaic system are not limited thereto, that is, the photovoltaic system may be applied in all fields that need to use solar energy to generate power. Taking a photovoltaic power generation system network as an example, the photovoltaic system may include a photovoltaic array, a combiner box and an inverter; the photovoltaic array may be an array combination of a plurality of solar modules, for example, the plurality of solar modules may form a plurality of photovoltaic arrays, the photovoltaic arrays are connected to the combiner box; and the combiner box may collect currents generated by the photovoltaic arrays, and the collected currents are converted by the inverter into an alternating current required by the utility grid, and then are connected to the utility grid to implement solar power supply.

In the illustration of the description, the illustration of reference terms "an embodiment", "some embodiments", "an example", "a specific example", or "some examples" means that specific features, structures, materials, or characteristics described in connection with the embodiment or example is included in at least one embodiment or example the present application. In the description, the illustrative expressions of the described terms do not necessarily refer to the same embodiment or example. Furthermore, the specific features, structures, materials, or characteristics described may be combined in any suitable manner in one or more embodiments or examples.

In addition, the described content merely relates to preferred embodiments of the present application, and is not intended to limit the present application, and any modifications, equivalent replacements, improvements, etc. made within the spirit and principle of the present application shall all fall within the scope of protection of the present application.

## Claims

1. A back contact cell, comprising a cell substrate and first insulation members, wherein fingers having two polarities are alternately arranged on a back surface of the cell substrate; the back surface comprises current collection regions and non-current collection regions which are distributed in a staggered manner; and the first insulation members are arranged at edges of the non-current collection regions in a continuous manner in an extension direction of the current collection regions, and cover portions of the fingers located in the non-current collection regions close to the current collection regions.

2. The back contact cell according to claim 1, wherein a thickness of the first insulation member is 10µm to 50µm.

3. The back contact cell according to claim 1, wherein a width of the first insulation member at the edge of the non-current collection region is 100µm to 1000µm.

4. The back contact cell according to claim 1, wherein busbars are formed on the back surface, and the busbars are provided in the current collection regions and are exposed from the first insulation members.

5. The back contact cell according to claim 4, wherein a ratio of a coverage area of the first insulation members to a total area of the back contact cell is 10% to 20%.

6. The back contact cell according to claim 1, wherein the back contact cell is a busbar-free cell; a part of each of the fingers is located in the current collection region; a rest part of each of the fingers is located in the non-current collection region; each of the current collection regions is provided with an interconnector; and the current collection region corresponding to each interconnector exposes fingers having a same polarity.

7. The back contact cell according to claim 6, wherein the current collection region is provided with fingers of one polarity, and the current collection region is fully exposed from the first insulation member.

8. The back contact cell according to claim 6, wherein the current collection region is provided with fingers having two polarities; the back contact cell comprises second insulation members; and the second insulation members cover, in the current collection region, fingers having a polarity opposite to the interconnector corresponding to the fingers.

9. The back contact cell according to claim 8, wherein a ratio of a sum of a coverage areas of the first insulation members and the second insulation members to a total area of the back contact cell is 5% to 15%.

10. The back contact cell according to claim 1, wherein the back contact cell comprises third insulation members; and the third insulation members are continuously provided in each of the non-current collection regions, extending from the first insulation member in an extension direction of the fingers, and at least partially covering the fingers having a polarity opposite to the current collection region corresponding to the fingers.

11. The back contact cell according to claim 10, wherein a ratio of a sum of lengths of the third insulation members corresponding to two adjacent fingers to a spacing between the first insulation members at two ends of the non-current collection region is less than or equal to 150%.

12. The back contact cell according to claim 11, wherein the ratio of the sum of lengths of the third insulation members corresponding to two adjacent fingers to the spacing between the first insulation members at two ends of the non-current collection region is greater than or equal to 100% or less than or equal to 120%.

13. The back contact cell according to claim 10, wherein a width of the third insulation member is 50µm to 500µm.

14. The back contact cell according to claim 10, wherein a difference between a width of the third insulation member and a width of the finger corresponding to the third insulation member is 20µm to 200µm.

15. The back contact cell according to claim 1, wherein the first insulation member is a transparent insulation member.

16. The back contact cell according to claim 15, wherein the first insulation member is a transparent fluorescent insulation member.

17. The back contact cell according to claim 15, wherein the transparent fluorescent insulation member is made of a transparent insulation adhesive, and the transparent insulation adhesive comprises:
a resin component with a mass percentage of 60%-80%;
an inorganic filler with a mass percentage of 5%-15%;
a curing agent with a mass percentage of 5%-15%;
a solvent with a mass percentage of less than 10%; and
a fluorescent agent with a mass percentage of greater than or equal to 0.1% and less than 1%.

18. The back contact cell according to claim 17, wherein the fluorescent agent comprises at least one of fluorescent brightener OB-1, fluorescent brightener OB, aluminum oxide, zinc oxide, zinc sulfide, calcium sulfide, strontium sulfide, strontium aluminate, calcium chlorate, barium aluminate, rare earth fluorescent materials, fluorescent brightener BC, fluorescent brightener JD-3, fluorescent brightener BR, fluorescent brightener EBF, fluorescent brightener R, fluorescent brightener ER, 1,8-naphthalimide fluorescent compounds, polybenzene, polythiophene, polyfluorene, polytriphenylamine, polytriphenylamine derivatives, polycarbazole, polypyrrole, polymeric porphyrin and its derivatives, copolymers, N,N-dimethylaminobenzylidene dinitrile compounds, 8-hydroxyquinoline aluminum, and europium metal complexes.

19. A solar module, comprising the back contact cell according to any one of claims 1 to 18.

20. A photovoltaic system comprising the cell module according to claim 19.
